# EUROPEAN PATENT APPLICATION

(11) **EP 0 593 387 A2**
(43) Date of publication of application: **20.04.1994**
(21) Application number: 93480136.6
(22) Date of filing: 21.09.1993
(51) Int. Cl.: G03F 7/20

(54) **Electron-beam lithography with induced currents**

(30) Priority: 13.10.1992 US 959866
(71) Applicant: INTERNATIONAL BUSINESS MACHINES CORPORATION, Armonk, N.Y. 10504 (US)
(72) Inventor: Ganin, Eti, Cortland Manor, New York 10566 (US); Hohn, Fritz Jurgen, Somers, New York 10589 (US); Newman, Thomas Harold, Mount Kisco, New York 10549 (US); Sai-Halasz, George Anthony, Mount Kisco, New York 10549 (US)
(74) Representative: de Pena, Alain

(57) **Abstract**

An electron-beam lithographic process using induced currents is disclosed. An electric field above the avalanche threshold is induced across a resist layer on a substrate. An area of the resist layer is exposed to an electron-beam, causing an induced avalanche-type current in the resist in the area of exposure, for creation of a fine integrated circuit feature. The field may be variable to control the intensity of the avalanche effect.

## Description

### BACKGROUND OF THE INVENTION

### Technical Field

The present invention relates generally to a lithographic process for fabricating integrated circuit features on a substrate. More particularly, the present invention relates to an improved electron-beam lithographic process for fabricating fine integrated circuit features on a substrate in actual production.

### Background Art

Lithography allows for small feature creation in VLSI technology. Today, lithography is usually done by exposing a photoresist coating on a substrate to light, causing chemical changes in the photoresist necessary for further processing, as is widely known in the art. These chemical changes depend on the particular type of resist used. A negative resist, used to make areas of the resist exposed to radiation more resistant to a solvent, induces polymerization. A positive resist, used to make areas of the resist exposed to radiation less resistent to a solvent, induces decomposition of a sensitizer in the resist. The term "cure" will be used herein to refer to these chemical changes in the general sense.

As feature size decreases, photolithography is limited due to the wavelength of light, which is larger than the feature sought to be created. The obstacle of the wavelength limitation of light has been attacked several ways. One solution is the use of x-rays instead of light as an energy exposure medium, since the wavelength is much smaller than that of light. Another solution using optics is to move to ultra violet light, but that ultimately has limitations similar to visible light. Still another solution uses an electron-beam exposure medium.

It is generally accepted that electron-beam lithography is the preferred method for fabricating submicron circuits. However, E-beam lithography suffers from a slow exposure rate (ie., low throughput), preventing its use in production. Rather than increasing E-beam intensity, much work has been done in trying to make more sensitive resists, so that the E-beam need not deliver as much charge per unit area of resist. To date, no resist has been developed with the sensitivity required to achieve a throughput that would allow E-beam lithography to be utilized in a production environment.

Absent a more sensitive resist, conventional E- beam lithography requires a relatively strong E-beam (i.e., high current). Electrons, being of the same charge, tend to repel each other. This causes a trajectory problem, and as the number of electrons increases, there is an energy broadening of the E-beam. Resolution varies directly with both E-beam energy and trajectory displacement. Thus, a lower current would increase resolution. In addition, the E-beam causes so-called proximity effects. There are two proximity effect components, a long-range component and a short-range component. The long-range component involves electrons in the resist having similar energy to the primary electrons in the E-beam. As the primary electrons penetrate through the resist to the substrate, they cause similar energy electrons in the substrate to scatter into the resist and distort the feature intended to be produced. This long-range component is also known as backscattering and will be discussed in further detail below. The short-range proximity effect component involves electrons in the resist of lesser energy than the primary electrons. As these electrons have less energy, the distance they can migrate before losing their energy is short. Thus, distortion caused by short-range electrons is far less than that caused by long-range electrons. Some work has been done in reducing the short-range proximity effect component, but the prior art has not addressed the backscattering problem. For an example of a proposed solution to the short-range proximity effect component problem, see Japanese Patent No. 60-178623 issued to Toshiba, entitled "Charged-Beam Exposure Method."

While the prior art does provide some different or temporary solutions to the limitation created by the wavelength of light, few utilize the preferred E-beam system technology in production for creating fine features in integrated circuits in demand today and on into the future, and none utilizes an E-beam system that eliminates backscattering. Since E-beam systems suffer from critical throughput problems, E-beam technology has had very little use in production. Thus, a need exists for a practical high resolution E-beam system that allows for image controllability and eliminates both components of the proximity effect, while not sacrificing throughput.

### DISCLOSURE OF INVENTION

Briefly, the present invention satisfies the need for a high resolution E-beam lithography system capable of use in a production environment and overcomes the above-noted deficiencies. In the inventive process, a substrate is coated with a layer of resist, across which an electric field is induced. An area of the resist is then exposed to an electron beam, causing an avalanche-type current to be induced in the resist in the area of exposure. This process vastly increases throughput, allows for the creation of fine features, and eliminates the proximity effects associated with conventional E-beam systems.

In a second embodiment of the invention, a high resolution electron exposure instrument, such as a Scanning Tunneling Microscope, is placed in close proximity to th'e resist layer for electron delivery. The E-beam current is very small, while accuracy in electron placement is very high. With an electric field across the resist, this small E-beam current still causes the avalanche effect and throughput is not a problem.

These, and other objects, features and advantages of this invention will become apparent from the following detailed description of the presently preferred embodiments of the invention taken in conjunction with the accompanying drawings.

### BRIEF DESCRIPTION OF THE DRAWINGS

FIG. 1 depicts a cross-sectional view of proximity effects of electron backscattering in a conventional electron-beam lithographic process.

FIGs. 2a, 2b depict a top view of residual uncompensated proximity effects due to intended feature shape in a conventional electron-beam lithographic process.

FIG. 3 depicts a cross-sectional view of an electron-beam lithographic process according to the present invention.

FIG. 4 depicts the electron-beam lithographic process of FIG. 3 implemented with a high resolution electron exposure instrument according to a second embodiment of the invention.

### BEST MODE FOR CARRYING OUT THE INVENTION

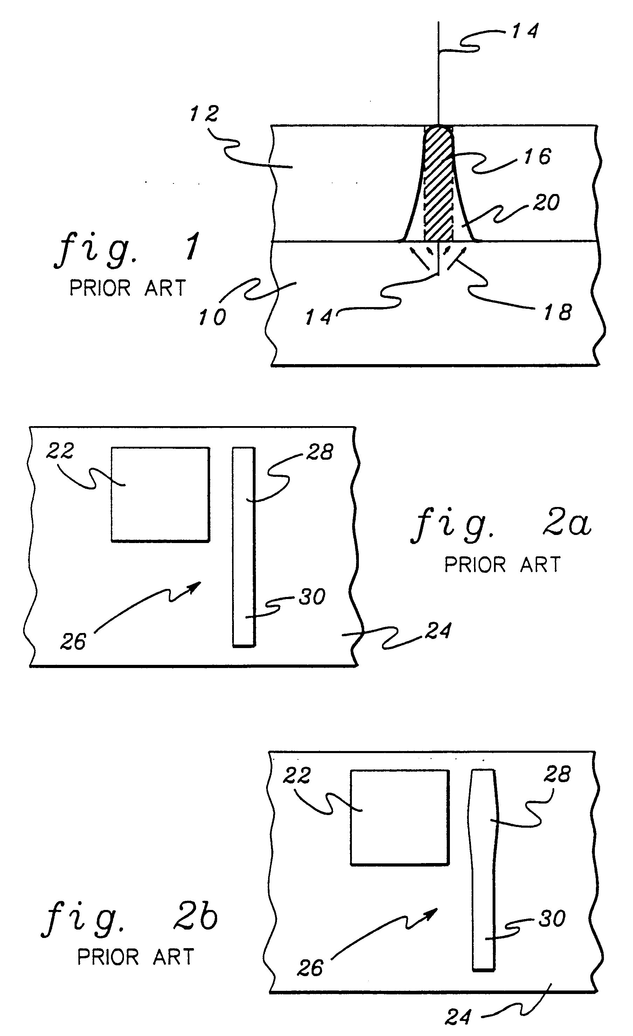

FIG. 1 depicts the effects of a conventional E- beam lithography system. Substrate 10 is covered with resist layer 12. Electron beam 14 is used to create intended feature 16 in the resist. Electron beam 14 primary electrons penetrate substrate 10, causing a backscattering 18 of electrons, resulting in a distortion 20 of the intended feature 16. It will be understood that the primary electrons are substantially absorbed in resist layer 12.

FIG. 2a depicts a top view of neighboring features 22 and 26 desired to be created in resist 24 using E-beam lithography. As the E-beam (not shown) creates feature 22, backscattering electrons penetrate into region 28 of feature 26. This results in undesired curing of feature 26 in region 28, causing a widening of feature 26 in region 28 compared to region 30, as shown in FIG. 2b.

Conventional E-beam lithography suffers from the backscattering effect, as well as low throughput and short-range proximity effects. The present invention presents solutions to all of these limitations on conventional E-beam lithography through a unique combination of electron beam exposure and electric field inducement of an avalanche effect in a resist.

Every material has a threshold electric field above which the so-called avalanche effect begins. The avalanche effect is known, and is basically a large current produced by electrons within a given material when an electric field above the threshold is placed across the material and "catalyst" electrons are introduced into the material. See, for example, G. A. Sai-Halasz and G. Gazecki, Influence of an Electric Field On Beam-induced Adhesion Enhancement, 45 Appl. Phys. Lett. 1067 (1984). This threshold depends on the type of material in which avalanche will occur. In the present invention, the material of interest is a resist.

An avalanche current will not be induced in a resist until the threshold electric field has been surpassed. Up until that point, another effect takes place which affects the resist, but on a much smaller scale than the avalanche effect and does not eliminate both components of the proximity effect. That pre-avalanche effect is known as Corona discharge. For an example of a prior art Corona discharge E-beam exposure method, see Japanese Patent No. 60-258921 issued to Toshiba, entitled "Method For Exposure by Ion Beam."

The present invention, for the first time, utilizes the avalanche effect in combination with E- beam lithography to cure the resist using less energy. Since the avalanche effect increases super-linearly with increasing field strength, the resist can easily receive from 100 to 1000 times the exposure that it would have received from the E-beam without the induced field. This means that the E-beam can spend less time over a given area (i.e., throughput is dramatically increased), as well as deliver less charge (i.e., a lower E-beam current).

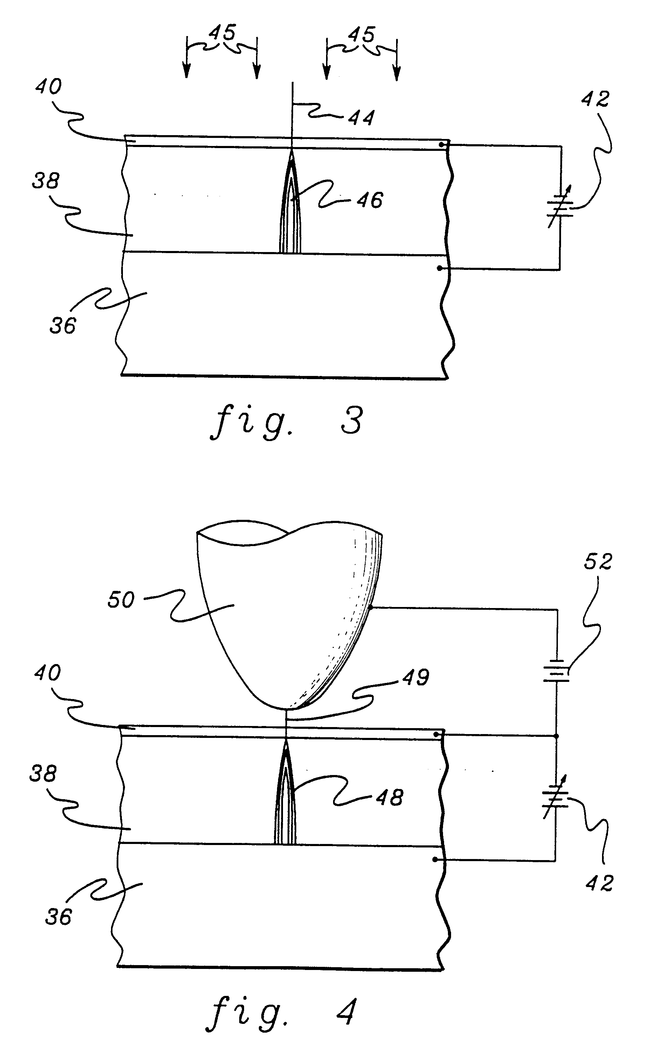

FIG. 3 depicts an electron-beam lithographic process according to the present invention. A cross- sectional view of a portion of substrate 36 is shown covered by a layer of resist 38 of standard thickness, approximately 0.1 to 2.0 microns. The resist layer 38 is coated with a layer of conductive material 40. Typically, the substrate 36 is a silicon wafer, and the conductive material 40 is a metal, such as aluminum. The conductive layer 40 is on the order of 100 angstroms in thickness. A bias potential 42 is connected between the conductive layer 40 and the substrate 36. Electron path 44 depicts the path of an electron which is part of an electron-beam 45 created in a conventional way. It will be understood that the selected area electron beam 45 cures may comprise a portion of resist layer 38 or the entire layer. Avalanche current 46 within the resist layer 38 is created by the combined action of an electron following path 44 and an electric field within resist 38 created by variable bias potential 42.

In FIG. 3, the electric field induced in resist 38 is produced by the variable bias potential 42. Thus, a desired avalanche effect intensity can be achieved through variation in bias potential 42. The voltage used to create the field across the resist depends directly on the thickness of the resist. For example, doubling the resist thickness would require a doubling of the voltage to produce the same field strength. Conductive layer 40, used here primarily to create the electric field across resist 38, is often used in resist systems as a charge draining layer. Resist is an insulator, and usually relatively thick, so a charge build-up due to the E-beam needs to dissipate, as a charge build-up in the resist may cause E-beam deflection. A conductive layer allows the charge to dissipate, and prevents E-beam deflection. Thus, in most systems, the addition of conductive layer 14 is not an additional step that must be performed.

After the initial lithographic process is complete, the conductive layer 40 is removed, and the resist goes through the usual development. Often, the conductive layer 40 is removed by dissolving in a standard developer. At the next lithographic level, the process is repeated.

It has been found that the addition of an electric field across the resist inherently eliminates short-range proximity effects. Electrons involved in the avalanche process are typically of relatively low energy, approximately a few hundred electron volts. With low energy, the electrons cannot migrate very far or cause other electrons to migrate far, thus eliminating short-range proximity effects. The direction of the field has not been found to affect this inherent effect. However, it will be understood that certain materials may require, or have more of a pronounced inherent effect with a particular electric field direction. To eliminate any remaining long-range proximity effects or backscattering, variation of the electric field in the resist can be used.

The process of the present invention can be used to compensate for the distortion depicted in FIG. 2b by lessening the intensity of the electric field (decreasing the variable potential bias) through feature 22, while not decreasing the field strength to or below the threshold. This results in a lessening of the avalanche current effect, and an elimination in the amount of backscattering not eliminated by the addition of the initial electric field across the resist. This also eliminates the FIG. 2b distortion in region 28 of feature 26.

The varying of the electric field depending on which feature, or which area of a given feature, is being created involves both monitoring and a predetermination of when backscattering overlap may occur. Predetermination of potential backscattering overlap areas is known in the art, and will not be further explained. One example is, as shown in FIGs. 2a, 2b, two features created close to one another.

The first embodiment of the invention provides for the use of the avalanche effect in a resist in the context of E-beam lithography. This greatly enhances throughput over conventional E-beam lithography, eliminates short-range proximity effects, and provides excellent image controllability. The first embodiment also provides for the elimination of long-range proximity effects (backscattering) existing in conventional E-beam lithography by providing for a variable electric field strength across the resist to adjust the intensity of avalanche effect in sensitive areas of the feature sought to be produced.

FIG. 4 depicts a second embodiment of the present invention. The E-beam lithography set-up of FIG. 4 is similar to that of FIG. 3, except for the electron delivery system. Resist 38 is of standard thickness, approximately 0.1 to 2.0 microns. In general, the resist is typically not much thicker than the feature sought to be created. In this second embodiment, avalanche current 48, induced by incident electrons following path 49, can create even finer features than tne avalanche current 46 of FIG. 3. A high resolution electron exposure instrument, such as a scanning tunneling microscope (STM), can be sued in conjunction with the avalanche effect to create such ultra-fine features. In conventional E-beam lithography using an STM, only extremely thin resist layers could be exposed (less than about 0.05 microns). This is due to the fact that STMs deliver low energy electrons in few numbers. Thus, STMs were impractical for use in semiconductor manufacturing, where the resist must be thicker than about 0.5 microns. The use of the avalanche effect solves this limitation on STM use in E-beam lithography and allows for ultra-fine feature creation in a production environment.

The tip 50 of a Scanning Tunneling Microscope (STM) (not shown) provides electrons in much fewer numbers than conventional E-beam systems, the STM tip being on the atomic scale, while also providing greater accuracy in their placement. Thus, an STM cannot cure the entire resist layer at once. Rather, an area limited by the electron beam width out of the STM may be exposed.

STM tip 50 is placed in close proximity to conducting layer 40. This distance is small, on the order of 0.001 microns to 0.1 microns. A bias potential 52, on the order of 10-100 volts, is created between STM tip 50 and conducting layer 40 to ensure accuracy in electron placement. The higher the voltage, the greater the distance between STM tip 50 and conducting layer 40. STM tip 50 is at a lower potential than conducting layer 40 so the electrons out of the tip are attracted to the conducting layer.

Electrons supplied by the STM typically have energy on the order of a few electron volts. With such low energy and in such few numbers, the proximity effects seen in conventional E-beam lithography are not of concern.

It will be understood that although a Scanning Tunneling Microscope has been specifically referred to, other equipment such as the Scanning Force Microscope could be used for high resolution electron exposure.

The present invention, as exemplified by the embodiments described herein, advances the state of the art by providing a high resolution E-beam lithography process with greatly enhanced throughput. This allows E-beam lithography, the preferred process for creation of fine features in resist layers, to be used in actual production. The present invention also inherently eliminates most of the proximity effects associated with E-beam lithography, and allows for correction of any remaining proximity effects by providing for a variable electric field in the resist layer. In a second embodiment of the invention, ultra-fine features can be created through an improved electron delivery system giving much greater control over the placement of fewer electrons.

## Claims

1. A lithographic process for fabricating fine integrated circuit features on a substrate, comprising:
depositing a layer of resist on a surface of said substrate;
inducing an electric field above avalanche threshold across said resist layer; and
exposing a selected area of said resist layer to an electron beam such that said electron beam in conjunction with said induced electric field cause an avalanche-type current in said resist in said area of exposure sufficient to cure the resist.

2. The process of claim 1, wherein said electric field is induced across said resist layer by:
depositing a layer of conductive material over said resist layer; and
applying a bias potential between said conductive layer and said substrate.

3. The process of claim 1, wherein said resist layer is of thickness 0.1 to 2.0 microns.

4. The process of claim 1, wherein said electric field induced across said resist layer is variable.

5. The process of claim 4, wherein said variable electric field across said resist layer is varied to control the intensity of said avalanche-type current within said resist layer.

6. The process of claim 4, wherein said variable electric field across said resist layer is varied to eliminate proximity effects in said resist layer due to electron-beam exposure.

7. The process of claim 1, wherein said substrate is a silicon wafer.

8. The process of claim 2, wherein said conductive material is aluminum.

9. The process of claim 2, wherein said bias potential applied between said conductive layer and said substrate is a forward bias.

10. The process of claim 2, wherein said bias potential applied between said conductive layer and said substrate is a reverse bias.

11. The process of claim 1, wherein said resist is a positive resist.

12. The process of claim 1, wherein said resist is a negative resist.

13. An integrated circuit produced using the process of claim 1.

14. A lithographic process for fabricating ultra-fine integrated circuit features on a substrate, comprising:
depositing a layer of resist on a surface of said substrate;
inducing an electric field above avalanche threshold across said resist layer; and
exposing a limited area of said resist layer to electrons using a high resolution electron exposure instrument such that incident electrons in conjunction with said induced electric field cause an avalanche-type current in said resist limited-exposure area sufficient to cure the resist.

15. The process of claim 14, wherein said resist layer is of thickness 0.1 to 2.0 microns.

16. The process of claim 14, wherein said electric field is induced across said resist layer by:
depositing a layer of conductive material over said resist layer; and
applying a bias potential between said conductive layer and said substrate.

17. The process of claim 14, wherein said electric field induced across said resist layer is variable.

18. The process of claim 17, wherein said variable electric field across said resist layer is
varied to control the intensity of said avalanche-type current within said resist layer.

19. The process of claim 17, wherein said variable electric field across said resist layer is varied to eliminate proximity effects in said resist layer due to electron exposure.

20. The process of claim 16, wherein said bias potential applied between said conductive layer and said substrate is a forward bias.

21. The process of claim 16, wherein said bias potential applied between said conductive layer and said substrate is a reverse bias.

22. The process of claim 14, wherein said incident electrons are supplied by a process comprising:
applying a layer of conductive material over said resist layer;
positioning said high resolution electron exposure instrument in close proximity to said conductive layer over said limited resist layer area; and
applying a bias potential between said high resolution electron exposure instrument and said conductive layer.

23. The process of claim 16, wherein said incident electrons are supplied to said layer of conductive material by:
positioning said high resolution electron exposure instrument in close proximity to said conductive layer over said limited resist layer area; and
applying a bias potential between said high resolution electron exposure instrument and said conductive layer.

24. The process of claim 14, wherein said resist is a positive resist.

25. The process of claim 14, wherein said resist is a negative resist.

26. The process of claim 14, wherein said high resolution electron exposure instrument is a Scanning Tunnel Microscope.

27. An integrated circuit produced using the process of claim 14.
